(19) Europäisches Patentamt
European Patent Office
Office européen des brevets

(11) Publication number: **0 132 337**
**A2**

(12) # EUROPEAN PATENT APPLICATION

(21) Application number: **84304650.9**

(22) Date of filing: **06.07.84**

(51) Int. Cl.⁴: **G 01 N 24/08**, A 61 B 5/05

(30) Priority: **21.07.83 US 515957**

(43) Date of publication of application: **30.01.85 Bulletin 85/5**

(84) Designated Contracting States: **DE FR GB**

(71) Applicant: **THE REGENTS OF THE UNIVERSITY OF CALIFORNIA, 2200 University Avenue, Berkeley, California 94720 (US)**

(72) Inventor: **Crooks, Lawrence E., 5439 Sacramento Avenue, Richmond California 94720 (US)**
Inventor: **Hoenninger, John C., III, 281 Cross Road, Oakland California 94618 (US)**

(74) Representative: **Smith, Norman Ian et al, F.J. CLEVELAND & COMPANY 40-43 Chancery Lane, London WC2A 1JQ (GB)**

(54) **Apparatus and method for reducing aliasing in sagittal or coronal NMR imaging.**

(57) An analog-to-digital sampling rate substantially higher than the Nyquist frequency $2f_c$ usually associated with the cut-off frequency $f_c$ of a low pass NMR response signal filter (21) is employed to reduce NMR image artifact caused by aliasing effects in the digital signal image reconstruction process. In effect, the outer limits of the displayed NMR image field-of-view (in at least one dimension) are defined by the cut-off frequency $f_c$ of the low pass filter (21) rather than by the sampling rate which is, in the preferred exemplary embodiment approximately as great as $4f_c$.

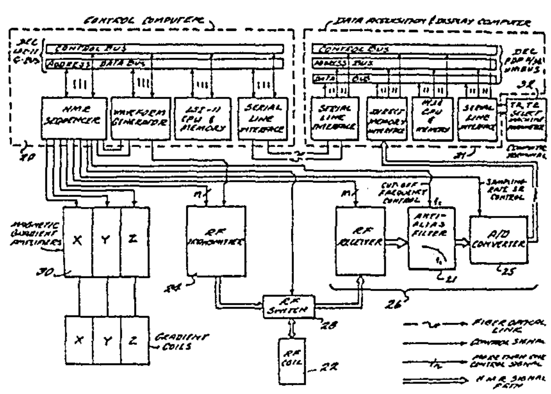

EP 0 132 337 A2

# APPARATUS AND METHOD FOR REDUCING ALIASING IN SAGITTAL OR CORONAL NMR IMAGING

## SPECIFICATION

This invention relates to apparatus and method for NMR (nuclear magnetic resonance) imaging wherein data representing the internal point-by-point distribution of selected molecular structures within an object under test are obtained using nuclear magnetic resonance phenomena. More particularly, this invention relates to digitized signal generation of NMR images with greatly reduced aliasing artifacts and is especially useful when imaging only a portion of a cross-sectional plane through an extended region of an object such as is typically desired for sagittal and/or coronal image planes through the human body.

This application is related to copending applications 84304649.1, 84304651.7, 84304652.5, filed concurrently herewith and to U.S. Patents Nos. 4,318,043, 4,297,637 and U.S. Application Serial No. 331,008.

NMR imaging is based on the ability to induce and monitor resonance of the magnetic moment of selected nuclei in the presence of magnetic fields. By the use of position-variant magnetic fields, it is possible to measure both the location and concentration in small volumes of resonant nuclei and, thereby, to create a visual display image that reflects this distribution in living tissue (e.g., a human body) or in other internal structures of an object under examination. Hydrogen, because it is the most sensitive of the stable nuclei to NMR phenomena and because it is also the most abundant nucleus in the human body, is ideally suited for NMR imaging. NMR imaging is a non-invasive diagnostic technique having some general similarity to computed tomography scanning (e.g. utilizing x-ray radiation) albeit it is based upon an entirely different physical phenomenon.

A detailed explanation of the particular NMR spin echo phenomena preferably used with the exemplary embodiment of this invention is already set forth in the related earlier referenced copending applications and issued patents.

The envelope of the radio frequency NMR signal response elicited from a region of interest is generally detected to provide an audio frequency NMR response signal (e.g. the envelope of a spin echo response). This audio frequency NMR response signal is subsequently sampled at repetitive intervals to provide digitized electrical signals representing the instantaneous signal value at the sample instants. These sampled values are also typically accumulated over repeated similar measurement cycles (e.g. so as to obtain an acceptable signal-to-noise ratio) and stored for subsequent NMR image reconstruction and display using a digital data signal processing apparatus. Typically, a digital Fourier transform technique (e.g. a Fast Fourier Transform) or the like is utilized to process the sampled signal values and to thus derive the magnitude of frequency components in the NMR response signal which are associated with different physical or spatial locations within the region of interest. That is, because of the magnetic gradient fields employed in the generation and read out of the NMR signal response, the spatial locations of nutated nuclei which provide the NMR response signal are encoded in the different frequency components of the NMR response signal.

As is well known, only a limited band of frequency components present in a signal are uniquely defined by such a discrete sampling process. In particular, as long ago recognized by Nyquist, periodic samples of a signal having a frequency greater than one-half the sample rate will have the same sampled point values as those for a signal having a frequency lower than one-half the sampled rate. Accordingly, when one derives the frequency spectrum of such a sampled waveform (e.g. by Fast Fourier Transformation), such higher frequencies (i.e. those above the Nyquist frequency) appear to occupy the same portion of the derived frequency spectrum as do the lower frequencies (e.g. those below the Nyquist frequency. This effect is sometimes known by the term "aliasing".

In NMR imaging, since the spatial location of nutated nuclei is encoded by the frequency of signal components present in the NMR response signal, the maximum frequency component in the derived frequency spectrum of the NMR signal effectively defines the maximum image size or the "field of view". Heretofore, an anti-aliasing electrical filter has been employed with a cut-off frequency $f_c$ equal to approximately one-half the signal sampling rate $2f_c$. That is, the sampling rate has been chosen heretofore in accordance with conventional practice as being substantially equal to the Nyquist frequency normally associated with the cut-off frequency of the low pass anti-aliasing filter. Thus, both the filter cut-off frequency and the sampling rate have in the past jointly acted to define a coextensive reconstruction field of view.

If a truly perfect or ideal anti-aliasing filter could be realized (e.g. one that completely and absolutely rejects all signal components having frequencies greater than the cut-off frequency and which passes without distortion or attenuation all signal components having frequencies less than the cut-off frequency), this prior conventional practice might be expected to prevent any aliasing artifact in the resulting NMR image.

However, in reality, it is not possible to physically realize such a perfect or ideal anti-aliasing filter. Thus, where there are in fact significant higher frequency components in the elicited analog NMR response signal, some magnitude of those higher frequency components can be expected to get past the anti-aliasing filter and to produce aliasing artifact in the resulting NMR image.

Such higher frequency components can typically be expected with sagittal or coronal cross-sections through the human body. This is due, for example, to the fact that a complete sagittal or coronal plane through the human body usually extends well beyond the field of view to be imaged (on one or the other or both ends) -- thus making it probable that high frequency components of significant magnitude are included within the NMR response elicited from the selected coronal or sagittal plane. Thus serious aliasing problems can be expected to occur more frequently and more severely with coronal and sagittal section NMR images than with transaxial NMR images.

The fact that typical prior art approaches even using sharp-skirted multi-pole low pass anti-aliasing filters do not totally alleviate the problem is shown, for example, by "Nuclear Magnetic Resonance (NMR) Tomography Of The Brain: Coronal And Sagittal Sections" by G.N. Holland et al, Journal of Computer Assisted Tomography, 4 (4):429-433, August, 1980.

However, we have now discovered that it is possible to substantially avoid aliasing artifacts altogether -- even from coronal and sagittal NMR images -- by forcing the sampling rate to be substantially greater than the nominal Nyquist sampling rate usually associated with the cut-off frequency of the low pass anti-aliasing filter. While the use of such a higher sampling rate does necessarily have some attendant disadvantages (e.g. it requires additional digital memory space to store the increased number of sampled values and increased processing time to process the increased number of sampled values), the advantage gained by reducing or substantially eliminating aliasing artifacts in the resultant image may well be considered worth the additional costs. Furthermore, the requirement for additional memory devices can be minimized by retaining only the more significant computed final image pixel values (e.g. those near the central portion of the field of view) for use in actual display. By this technique, the required memory for storing the computed image pixel values can be maintained equivalent to prior art memory requirements for storage of computed NMR images (although added memory to store the added samples will still be required).

In the preferred exemplary embodiment, the sampling rate is chosen to be at than (e.g. twice) the nominal Nyquist rate associated with the cut-off frequency of the low pass anti-aliasing filter. The NMR response signals used in the presently preferred exemplary embodiment are spin echos elicited by selectively exciting a first portion of the object with a 90° r.f. nutation pulse and thereafter selectively exciting a second portion of the object with a 180° r.f. nutation pulse so as to elicit a spin echo response from a region of interest defined by the common intersecting region of the first and second portions. The preferred exemplary embodiment also repetitively measures similar spin echo signals and accumulates the measured sampled values before using them in an NMR reconstruction step that preferably comprises a two-dimensional Fourier transformation of the thus measured and/or accumulated sampled signal values. Preferably, where a sagittal or coronal planar volume is being imaged, a magnetic gradient is applied along the long axis of the body during the NMR spin echo occurrence such that the real-time low pass analog signal filtering reduces aliasing along the long axis of the body where aliasing artifact is potentially most serious.

These as well as other objects and advantages of this invention will be better understood by carefully reading the following detailed description of a presently preferred exemplary embodiment of this invention when taken in conjunction with the accompanying drawings, of which:

IN THE DRAWINGS:

FIGURE 1 is an exploded perspective view of a suitable static magnetic coil and gradient coils for use with an exemplary embodiment of this invention;

FIGURE 2 is a block diagram of a computerized electronic apparatus that may be utilized for driving the magnetic gradient coils and the r.f. circuits including a transmitting/ receiving r.f. coil for an exemplary embodiment of this invention;

FIGURE 3 is a graphical depiction of an exemplary sequence of magnetic gradient and r.f. pulses that may be used for sagittal plane imaging with two-dimensional Fourier transformation reconstruction techniques and illustrating the sampling times utilized for sampling the depicted audio frequency envelope of the detected spin echo signal elicited from a selected sagittal plane;

FIGURE 4 is a graphical depiction of a digitized Fourier transformation process by which projected spin densities and eventually, point-by-point spin densities can be obtained from frequency components in the derived frequency spectrum of the measured spin echo signals;

FIGURES 5a and 5b illustrate the general type of aliasing artifact that may be expected when the reconstructed field of view as defined by the sampling rate is less than a corresponding dimension of the object from which the NMR response signals emanate;

FIGURE 6 illustrates the general type of frequency response curve for an anti-aliasing filter and the relationship between the reconstruction field of view as defined by the anti-alias filter, on one hand, and the reconstruction field of view as defined by the sampling rate SR, on the other hand;

FIGURE 7a is analogous to FIGURE 5a and comparatively illustrates the general type of aliased image reconstruction that may be expected using a conventional filtering/sampling arrangement while FIGURE 7b comparatively illustrates the general type of non-aligned image reconstruction that may be obtained by extending the reconstructed field of view via a greater sampling rate;

FIGURE 8 illustrates a sagittal imaging process in accordance with this invention as well as the aliasing artifact that could be expected without the use of the invention; and

FIGURE 9 illustrates a coronal imaging process in accordance with this invention as well as the aliasing artifact that might otherwise be expected.

The hard-wired apparatus employed in the presently preferred exemplary embodiment of this invention is similar to that employed and disclosed in the above-referenced copending patent applications from which FIGURES 1-2 have been substantially copied -- with the exception of the anti-aliasing filter 21 and its associated cut-off frequency control by the data acquisition and display computer 31 via the serial line interface and the control computer 20. The remaining functional differences in this equipment and in its operation which permit one to practice the presently described and claimed invention are achieved by reprogramming the data acquisition and display computer 31 so as to ensure that the sampling rate SR employed by the analog-to-digital converter 25 is substantially greater than the Nyquist frequency $2f_c$ associated with the cut-off frequency $f_c$ of the anti-alias filter 21 (e.g. at least twice the Nyquist rate in the preferred embodiment). Of course, the data acquisition and display computer 31 must be provided with sufficient additional memory and appropriate programming to ensure that the now larger number of sampled data values are processed and stored.

Referring to FIGURE 1, the present exemplary embodiment of this invention includes a static field magnetic coil 10 for generating a uniform static magnetic field $H_0$ directed along its axis. The coil 10 is, in the exemplary embodiment, preferably large enough to receive a human body and is preferably surrounded by a cryogenic housing 12 filled with liquid helium or the like so as to permit the coil 10 to be superconducting. In the exemplary embodiment, the static field is of approximately 3.5 KG thus making hydrogen nuclei exhibit NMR at approximately 15 MHz frequency. The X gradient coils, Y gradient coils and Z gradient coils shown in explosed perspective at FIGURE 1 are actually concentrically superimposed within the static field magnetic coil 10 and are preferably constructed so as to receive at least a portion of the human body therein. The RF transmit/receive coil is also of conventional design (as are the other coils shown in FIGURE 1) and is designed so as to cause the RF magnetic field to be perpendicular to the static magnetic field $H_0$ as will be appreciated by those in the art.

Exemplary electronic apparatus for sequentially driving the various magnetic and RF coils is shown in simplified form at FIGURE 2. Referring to FIGURE 2, a computerized control system 20 is in communication with the data acquisition and display computer 31 via a serial line link. This control system constitutes the NMR system control which controls the amplitude, timing and/or phasing of the necessary transmitted RF pulses, current drives to the magnetic gradient coils and RF detection processes required for NMR. It includes conventional data storage, data output/input and data entry components as appropriate to the requirements of a particular installation. The computer control system 20 typically also comprises plural data processors operating in parallel under control of a host data acquisition and display processor 31. Except for the particular novel anti-aliasing filtering/sampling and reconstruction sequences and/or functions to be performed (e.g. as set forth in detail hereinbelow), the NMR system control 20 is of conventional design or as described in the earlier referenced copending applications and patents. If desired, an array processor (e.g. CSPI Co. Model MAP 200) may be incorporated in the digital signal processing circuits to speed the required reconstruction digital data signal processing.

The r.f. coil 22 is used for both transmitting and receiving r.f. energy to/from the object under test. It is selectively communicated with by either the r.f. transmitter 24 or the r.f. receiver 26 (and its associated anti-aliasing filter 21 and A/D converter 25) via an r.f. switch 28 which is, in turn, controlled via a control line by the NMR system control 20. This portion of the apparatus is used for selectively transmitting nutation pulses of r.f. energy into the object under test (said pulses having programmable amplitude, frequency, phase and duration so as to effect a desired nuclei nutation) and for selectively detecting NMR r.f. spin echo responses from the object under test during programmable listening periods. The r.f. signal generator, the r.f. transmitter 24, r.f. receiver and A/D converter 26 and r.f. switch 28 may be of the type described in greater detail in the earlier referenced issued patents and/or copending applications.

The anti-aliasing filter 21 may be an audio frequency low pass filter -- preferably having controllable cut-off frequency $f_C$ so that the sampling rate SR and filter cut-off $f_C$ can both be jointly varied, if desired, while still retaining relative values in accordance with this invention. A model 602 dual anti-alias filter commercially available from Precision Filters, Inc. is one suitable such filter. The filter cut-off frequency $f_C$ and the A/D sampling rate SR are both preferably controlled by the data acquisition computer 31 via the control computer 20 and a conventional serial to parallel digital interface.

The magnetic gradient coil drivers 30 are controlled by the NMR system control 20 to selectively drive the X gradient coil, Y gradient coil and Z gradient coil with currents of programmable magnitude, duration, polarity, etcetera.

Because digital samples of spin echo signals from different but similar measurement cycles are combined in the exemplary embodiment before Fourier transformation or other multidimensional reconstruction processes, improved system performance can be obtained under certain conditions (e.g. where there is a residual FID component of error in the spin echo) if the relative phase of the RF excitation signals (and of reference RF signals used for frequency translation and synchronous demodulation in the receiver circuitry) are accurately controlled and phased relative to the initiation of each r.f. pulse and/or r.f. detection window.

Conventional data entry devices are associated with NMR control computer 20 in FIGURE 2 to permit selection of a desired machine parameter value for the TR and/or TE parameters. TR and TE are the American College of Radiology standard symbols for the parameters which were formerly called b and a parameters in some of the earlier referenced related copending applications. TR is the repetition time of the measurement sequence and affects T1 contrast. TE is the time delay of the spin echo after the 90° nutation pulse and affects T2 contrast.

FIGURES 3 and 4 are presented for a brief review of the preferred two-dimensional Fourier transformation reconstruction process described in above referenced related copending application Serial No. ___________, -- as modified so as to permit NMR imaging of a sagittal plane (e.g. a cross-section parallel to the Y-Z plane shown in FIGURE 1). In particular, it will be noted that whereas the Z gradient field was earlier used for transaxial images to select a transaxial planar volume to which the 90° and 180° nutation pulses are applied, now, as shown in FIGURE 3, an X gradient field is used to select a sagittal planar volume. Furthermore, the Z axis gradient is now employed during the spin echo read out so as to provide Z-axis phase encoding during the spin echo read out.

For coronal planar imaging, the role of the X and Y axis gradients would be substituted, one for the other, from the depictions shown in FIGURE 3.

As also depicted now in FIGURE 3, the spin echo signal (actually the detected audio frequency envelope of the radio frequency spin echo response signal) is sequentially sampled each t seconds at a sampling rate SR=1/t. A plurality of such sampled and NMR signal values are preferably accumulated over repetitive measurement cycles and then Fast Fourier Transformed to provide a digitized frequency spectrum representing line projections of the nutated spin densities. As depicted in FIGURE 4, because real-time Z-axis phase encoding was employed in FIGURE 3, the discrete frequency components obtained by Fast Fourier Transformation (each component is depicted in magnitude by an upstanding arrow of suitable length in FIGURE 4) represent line-projections of spin densities at different discrete corresponding spatial locations in a Z-axis dimension for a particular Y-axis phase encoded position. As depicted in FIGURES 3 and 4, this process is repeated for different Y-axis phase encoding positions. The result is an N by M array of frequency component values in frequency spectra obtained by Fast Fourier Transformation. As already stated, all the depicted frequency component values in FIGURE 4 actually represent projections of spin density values. However, if the functions defined by the transverse elements of this array (i.e. along a line parallel to the Y axis as depicted by dotted function line in FIGURE 4) are now Fast Fourier Transformed, this second dimension of Fourier transformation will provide point-by-point spin density values at N x M corresponding locations on the Y-Z plane (or on a plane parallel thereto).

As earlier explained, if an absolutely perfect or ideal anti-aliasing filter 21 could be physically realized, then there would be no frequency components in the sampled analog signal greater than one-half the sampling rate -- even where the sampling rate is conventionally chosen to be only about equal to twice the cut-off frequency of the anti-aliasing low pass filter. However, since it is not possible to realize such a perfect anti-aliasing filter, one can in reality expect significant frequency components above the cut-off frequency of the filter. As also earlier explained, such higher frequency components especially can be expected to be present in sagittal or coronal NMR image signals where the NMR signals are elicited from an extended coronal and/or sagittal plane along the long axis of the human body. Accordingly, under these conditions, it can be expected that aliasing artifact will be present in the Fourier transformed frequency component values used to reconstruct the NMR image.

The general nature of the aliasing artifact may be better appreciated by reference to FIGURES 5a and 5b. As shown in FIGURE 5a, when the NMR response signal emanates from a region of interest which is smaller than the reconstruction field of view, the region is correctly represented without aliasing artifact. However, if the signal producing region is larger than the reconstruction field of view, the higher frequency components of the NMR analog signal can be expected to alias so as to appear as pseudo-lower frequency components in the reconstructed frequency spectra used to reconstruct the image. Accordingly, a portion of the image can be expected to "scroll" or "wrap around" the boundary of the field of view as depicted in FIGURE 5b. The overlapping portions of this alias artifact may either add or subtract from the true or correct image intensity at any given point depending upon the relative phases of the true NMR signal component at the corresponding frequency and the aliased frequency component.

Since a perfect or ideal anti-aliasing low pass filter cannot be realized in practice, the actual frequency response curve of an anti-aliasing filter will be of the general type depicted at FIGURE 6 where frequency components above a given "cut-off" frequency $f_c$ are increasingly attenuated. The cut-off frequency of a filter is typically (although not necessarily) measured at the -3 decibel (dB) level of attenuation. Thereafter, the attenuation can increase at various rates depending upon the "sharpness" of the filter skirts (e.g. as depicted by solid skirt line 60 or, alternatively, a somewhat sharper dotted skirt line 62 at FIGURE 6).

Conventionally, the sampling rate SR is chosen to be twice the filter cut-off frequency $f_c$. Stated another way, the filter cut-off frequency $f_c$ is conventionally chosen to be one-half the sampling rate SR. For typical filter skirt sharpness, signal components occurring at twice the cut-off frequency might be expected to be attenuated by, for example, -36 decibels (i.e. an output signal which is only 1.58% of the input signal level at this frequency). Thus, even with the anti-aliasing filter in place, if conventional sampling rates are utilized, wrap around aliasing artifact can still be expected as depicted in FIGURE 7a even though the wrapped around or aliased image values can be expected to gradually fade away as also depicted in FIGURE 7a. This fading of the aliased signal components progresses as the aliased components approach the center of the field of view because these locations correspond to progressively higher aliased frequencies which are, in turn, therefore ever more attenuated by the anti-aliasing filter.

In a case where one expects to image a section from a relatively long object (e.g. as in a coronal or sagittal section through the human body), one can expect very strong high frequency components to be present in the analog NMR response signal. Accordingly, even after these signals are attenuated by the skirts of the anti-aliasing filter response curve, one can expect significant aliased frequency components in the reconstructed image. However, as we have discovered, if one causes the anti-aliasing filter alone to define the effective displayed field of view (e.g. by choosing a sampling rate substantially larger than the Nyquist frequency normally associated with the filter cut-off frequency so as to define a much larger reconstructed field of view), even the stronger high frequency components which pass through the skirts of the filter response curve will appear to fade out in their correct relative positions in the image (e.g. see FIGURE 7b). That is, such higher frequency components will not alias or "wrap around". In the preferred exemplary embodiment, the sampling frequency SR is substantially greater than twice the filter cut-off frequency $f_c$. The result is a reconstructed NMR image which fades away at its edges (due to the progressive attenuation of the filter curve within the considerably larger reconstruction field of view defined by the sampling rate) -- but which does not have any overlap or aliasing artifact.

The use of a relatively large reconstruction field-of-view (as defined by the sampling rate) as compared to the relatively smaller viewable field-of-view (as defined by the cut-off frequency of the anti-alias filter and the sharpness of its skirts) is an especially useful improvement for coronal and sagittal body imaging where the long axis of the body is typically much longer than the region of interest. It may also be useful in transaxial imaging if, for example, it is desirable to eliminate strong high frequency signal sources associated with the edge of the reconstructed field of view (e.g. arms at the sides of the patient).

In sagittal and coronal imaging, body tissues located both above and below the area of interest can and do produce strong NMR response signals. Thus, as shown in FIGURE 8, where the sensitive region of the r.f. pickup coil extends considerably beyond the brain region of interest, detected NMR response signals can be expected to also come from the neck region. Where a standard anti-aliasing filter and matching reconstruction field of view defined by the sample rate are used, aliasing artifact can be expected as depicted in FIGURE 8. However, by keeping the same filter setting but increasing the sampling rate for a wider reconstruction field of view, the aliasing artifact in the viewable image can be eliminated as also depicted in FIGURE 8. Similarly, coronal imaging of the heart and lungs can involve interfering NMR response signals emanating from, for example, the head and liver. These unwanted NMR signals can actually be much stronger than the relatively low NMR response signals expected from the air-filled lungs. Once again, as depicted in FIGURE 9, serious aliasing artifact can be expected with standard anti-aliasing filter and sampling rates. However, with a relatively higher sampling rate, the aliasing artifact can be eliminated in accordance with this invention.

Since the preferred exemplary embodiment of this invention utilizes a two-dimensional Fourier transformation reconstruction technique with phase encoding in one dimension (e.g. the Y axis dimension as depicted in FIGURES 1, 3 and 4) there is no ready equivalent of the real time electrical low pass filter in this phase encoded dimension which might be used so as to relieve aliasing problems in this Y-dimension. Accordingly, the phase encoding dimension is preferably chosen in a direction which naturally has a limited signal producing region less than the reconstruction field of view. In the preferred exemplary embodiment, the limited body thickness (front to back) is chosen in the sagittal case for the phase encoding axis and the limited body width (left to right) of the body is used for phase encoding in the case of coronal imaging. It is noted that if the r.f. pickup coil is designed to have a very limited region of sensitivity, then this may permit the phase encoding to be done along the long axis (e.g. Z axis in the exemplary embodiment) of the body. However, in the preferred exemplary embodiment, using the Y axis for phase encoding of a sagittal image and the X axis for phase encoding of a coronal image, it is necessary to use the long body axis (e.g. the Z axis) for phase encoding the real time NMR spin echo response signal for which the real time analog electrical anti-aliasing filter can be utilized to limit the effective field of view in accordance with this invention.

As depicted in FIGURES 8 and 9, a very wide reconstructed field of view image which shows the entire region of interest and the limited sensitivity region of the r.f. pickup coil provides protection against aliasing (i.e., the coil limits the frequency range of signals detected from along this dimension) at the cost of storing and processing much more data than the present invention. However, with an anti-aliasing signal filter whose cut-off frequency merely matches the minimum sample rate requirements (i.e. $SR=2f_C$) as is done conventionally, strong high frequency signal components emanating from the neck region can easily alias into and thus interfere with the brain image in the depicted sagittal example. Similarly, in the depicted coronal example, the neck and/or abdomen can alias and therefore interfere with the desired chest region image. However, as also depicted in FIGURES 8 and 9, by substantially increasing the sampling rate (e.g. $SR=4f_C$), the aliasing artifact can be significantly reduced. Of course, any frequency higher than one-half the increased sampling rate (e.g. higher than $2f_C$) will still be aliased. However, at these relatively higher frequencies, the anti-aliasing filter provides considerably more relative attenuation such that these still aliased but now much higher frequency components are reduced in magnitude -- even below detectability.

Of course, the sharper the filter skirts, the less one may have to increase the sampling rate so as to avoid significant aliasing artifact. Thus, if sharper skirted anti-aliasing filters are employed, it may not be necessary to have the sampling rate chosen at twice the natural Nyquist rate (e.g. at $4f_c$). However, in accordance with this invention, the sampling rate will still be chosen to be substantially higher than the natural Nyquist frequency (e.g. substantially higher than $2f_c$) such that the cut-off frequency of the anti-aliasing filter and its attenuation characteristics effectively define the displayed field of view -- rather than letting the sampling rate define not only the reconstruction field of view used in the reconstruction signal processing, but also the effective visible or displayed field of view. Using the model 602 anti-aliasing filter produced by Precision Filters Inc. we have found that a sampling rate of 2.4 $f_c$ is sufficient to produce images with no detectable aliasing.

If the desired image resolution in the area of interest is to be maintained the same as before this invention is employed, then the relatively increased sampling rates employed with this invention means that provisions must be made for storing and processing these additional sampled NMR signal values. Furthermore, there will be a correspondingly greater number of pixel values which may be calculated and displayed in the final image. However, these extra pixel values may not contain much real information due to the fact that the anti-aliasing filter has greatly attenuated the frequency components of the NMR signal corresponding to these outermost areas of the final image containing the extra pixels. Since this is the case, it may be desirable to simply program the computer to discard the reconstructed or computed pixel values and thus save on the data storage requirements for storing the computed pixel values to be used in displaying a final image. As will be appreciated by those in the art, the extra sample points, however, cannot themselves be discarded and must be used in the reconstruction process.

One typical example of using this invention would be for a sagittal brain scan where the anti-aliasing filter is set to have a cut-off frequency of 7 KHz while the analog-to-digital converter is controlled to sample every 36 microseconds, corresponding to a sampling frequency of approximately 28 KHz (meaning that signal components up to a maximum frequency of approximately 14 KHz may be reliably reconstructed in accordance with the theorems of Nyquist). Thus, in this example, 256 samples will be taken in a 9.2 millisecond interval during which an NMR spin echo envelope is to be captured. The digitized Fourier transform of these samples will then provide a 256 point discrete frequency spectrum, the center 128 points of which constitute the desired image region and the outer 64 points on either side of the center portion containing information which is gradually fading away due to the ever increasing attenuation of the anti-aliasing filter for signal components corresponding to these outer locations. If the fading outer portions of the reconstructed image are not needed, they can be discarded as mentioned above so that the resulting computed image values will require only approximately one-half the data storage space which would otherwise be required.

Other possible variations may be made in the above example. For example, one might use a filter cut-off frequency of 10 KHz so as to obtain a somewhat wider effective field of view in the displayed viewable image (i.e. before it fades away). In this case, fewer pixels could be discarded and there would be a somewhat greater chance of aliasing artifact as should now be appreciated.

As already explained, in the preferred exemplary embodiment, the anti-aliasing filter 21 may be an audio filter provided at the outputs of the r.f. demodulators and just ahead of the dual analog-to-digital converters 25. A model 602 dual anti-alias filter produced by Precision Filters Inc. is a suitable commercially available filter which has a remotely controlled cut-off frequency. This frequency cut-off control input and the A/D converter sample rate SR are each controlled by the data acquisition computer via the control computer and a serial to parallel digital interface in the preferred exemplary embodiment as earlier discussed.

Although only one presently preferred exemplary embodiment has been described in detail above, those skilled in the art will appreciate that there may be many modifications and variations made in this exemplary embodiment while still retaining many of the advantageous novel features of this invention. Accordingly, all such variations and modifications are intended to be included within the scope of the following claims.

WHAT IS CLAIMED IS:

1. A method of NMR imaging a region of interest in an extended object which reduces aliasing effects, said method comprising the steps of:

obtaining an NMR response signal from said region of interest and passing it through a low pass electrical filter having a cut-off frequency $f_c$;

successively sampling said filtered NMR response signal at a rate SR and measuring the value of the signal at each sample time interval, said sampling rate SR being substantially greater than $2f_c$; and

reconstructing from said measured signal values an NMR image of said region of interest with an effective field of view limited by said low pass filter cut-off frequency $f_c$.

2. A method of NMR imaging as in claim 1 wherein said sampling rate SR is at least as great as $4f_c$.

3. A method of NMR imaging as in claim 1 wherein said obtaining step comprises the steps of:

selectively exciting a first portion of the object with a 90° r.f. nutation pulse; and

thereafter selectively exciting a second portion of the object with a 180° r.f. nutation pulse so as to elicit a spin echo NMR response signal from a region of interest defined by the common intersecting region of said first and second portions.

4. A method of NMR imaging as in claim 1, 2 or 3, wherein said obtaining and sampling steps are repeated with the corresponding sampled signal values of each repetition being accumulated and the thus accumulated signal values being used in said reconstructing step.

5. A method of NMR imaging as in any preceding claim, wherein said reconstructing step includes two-dimensional Fourier transformation of said accumulated signal values.

6. A method of NMR imaging as in any preceding claim, wherein said passage through a low pass filter occurs after detection of the NMR response signal while it is in analog form.

7. A method of NMR imaging as in any preceding claim, wherein said region of interest is a sagittal planar volume through a human body, and wherein a magnetic gradient is applied along the long axis of the body during the NMR spin echo occurrence such that the low pass filtering reduces aliasing artifacts along the long axis of the body in the reconstructed NMR image.

8. A method of NMR imaging as in any one of claims 1 to 6, wherein said region of interest is a coronal planar volume through a human body, and wherein a magnetic gradient is applied along the long axis of the body during the NMR spin echo occurrence such that the low pass filtering reduces aliasing artifacts along the long axis of the body in the reconstructed NMR image.

9. Apparatus for NMR imaging a region of interest in an extended object which reduces aliasing effects, said apparatus comprising:

means for obtaining an NMR response signal from said region of interest and passing it through a low pass electrical filter having a cut-off frequency $f_c$ ;

means for successively sampling said filtered NMR response signal at a rate SR and measuring the value of the signal at each sample time interval, said sampling rate SR being substantially greater than $2f_c$ ; and

means for reconstructing from said measured signal values an NMR image of said region of interest with an effective field of view limited by said low pass filter cut-off frequency $f_c$ .

10. Apparatus as in claim 9, wherein said sampling rate SR is at least as great as $4f_c$ .

11. Apparatus as in claim 9, wherein said means for obtaining comprises:

means for selectively exciting a first portion of the object with a $90^o$ r.f. nutation pulse; and

means for thereafter selectively exciting a second portion of the object with a $180^o$ r.f. nutation pulse so as to elicit a spin echo NMR response signal from a region of interest defined by the common intersecting region of said first and second portions.

12. Apparatus as in any one of claims 9 to 11, wherein said means for obtaining and means for sampling includes means for accumulating corresponding sampling signal values obtained by repeated NMR signal measurements and wherein said means for reconstruction uses the thus accumulated signal values in said reconstructing.

13. Apparatus as in any one of claims 9 to 12, wherein said means for reconstructing includes means for effecting two-dimensional Fourier transformation of said accumulated signal values.

14. Apparatus as in any one of claims 9 to 11 wherein said low pass filter is located to intercept said NMR response signal thereof after detection while it is in analog form.

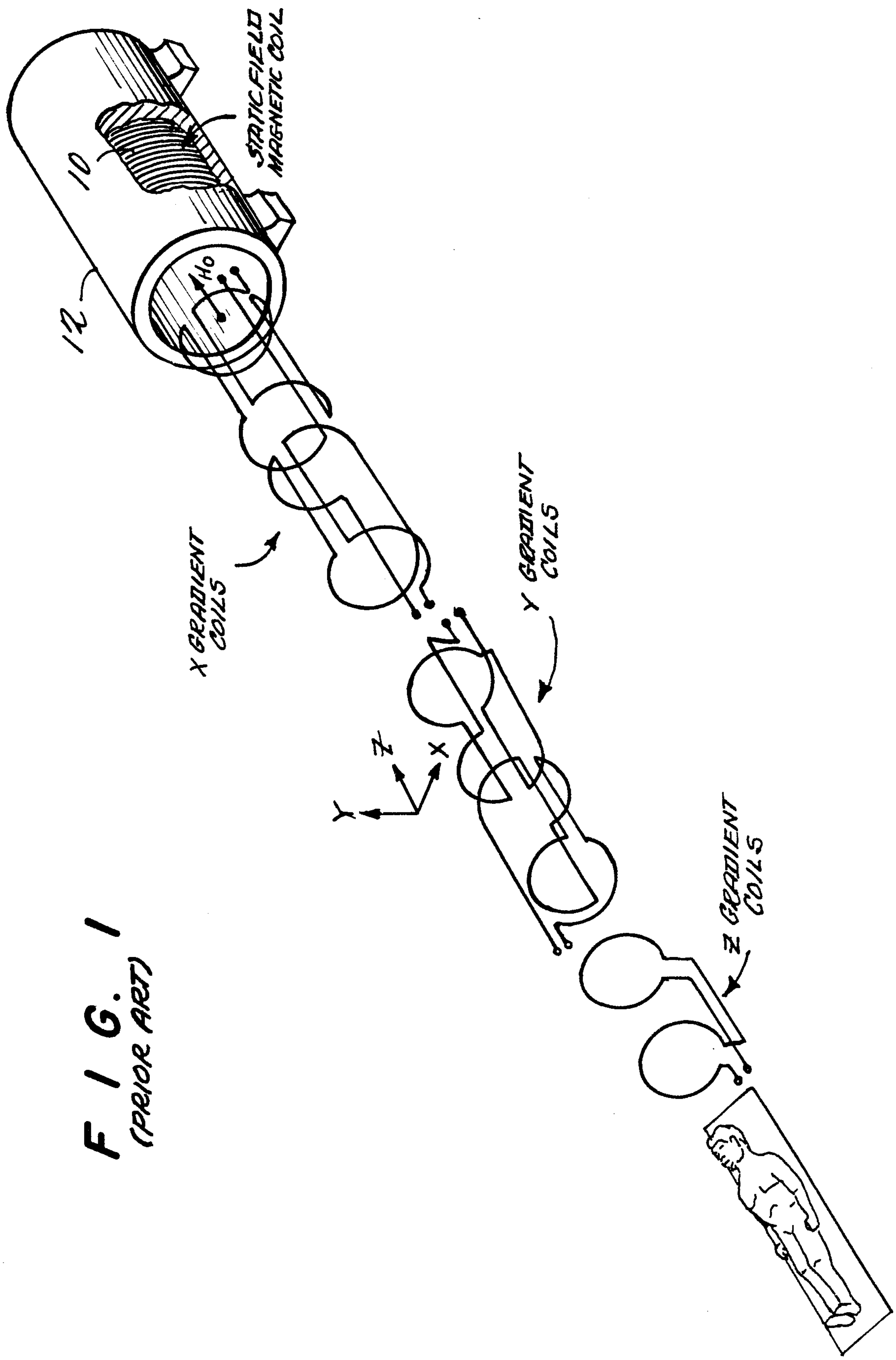


FIG. 1
(PRIOR ART)

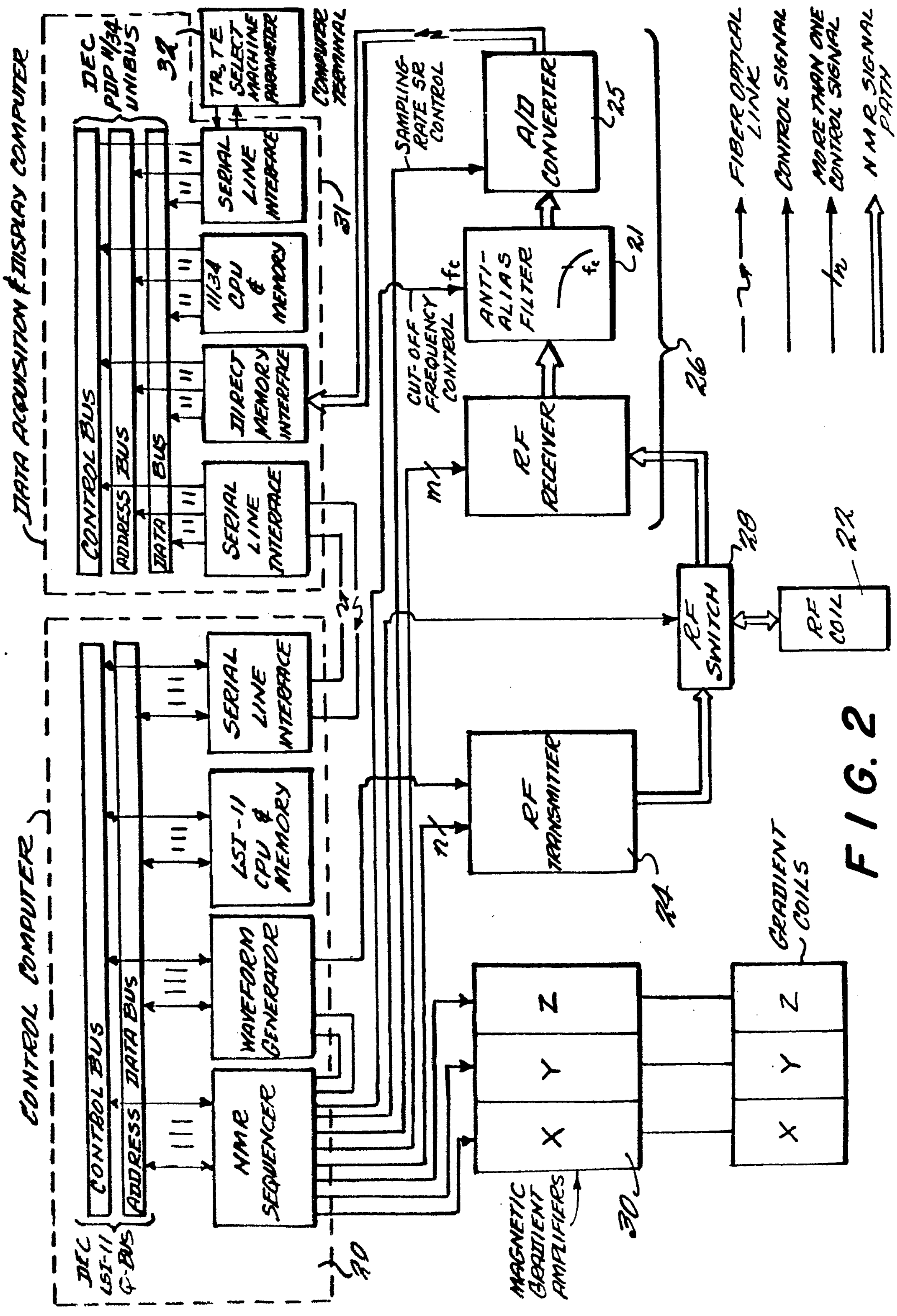
DATA ACQUISITION & DISPLAY COMPUTER
DEC PDP 11/34 UNIBUS
32
TR, TE SELECT MACHINE PARAMETER
COMPUTER TERMINAL
CONTROL BUS
ADDRESS BUS
DATA BUS
SERIAL LINE INTERFACE
11/34 CPU & MEMORY
DIRECT MEMORY INTERFACE
SERIAL LINE INTERFACE
31
CONTROL COMPUTER
CONTROL BUS
ADDRESS DATA BUS
DEC LSI-11 Q-BUS
SERIAL LINE INTERFACE
LSI-11 CPU & MEMORY
WAVEFORM GENERATOR
NMR SEQUENCER
20
SAMPLING RATE SR CONTROL
A/D CONVERTER
25
CUT-OFF FREQUENCY CONTROL
fc
ANTI-ALIAS FILTER
21
RF RECEIVER
26
m
RF SWITCH
28
RF COIL
22
n
RF TRANSMITTER
24
MAGNETIC GRADIENT AMPLIFIERS
30
X Y Z
GRADIENT COILS
X Y Z
FIBER OPTICAL LINK
CONTROL SIGNAL
MORE THAN ONE CONTROL SIGNAL
n
NMR SIGNAL PATH

FIG.2

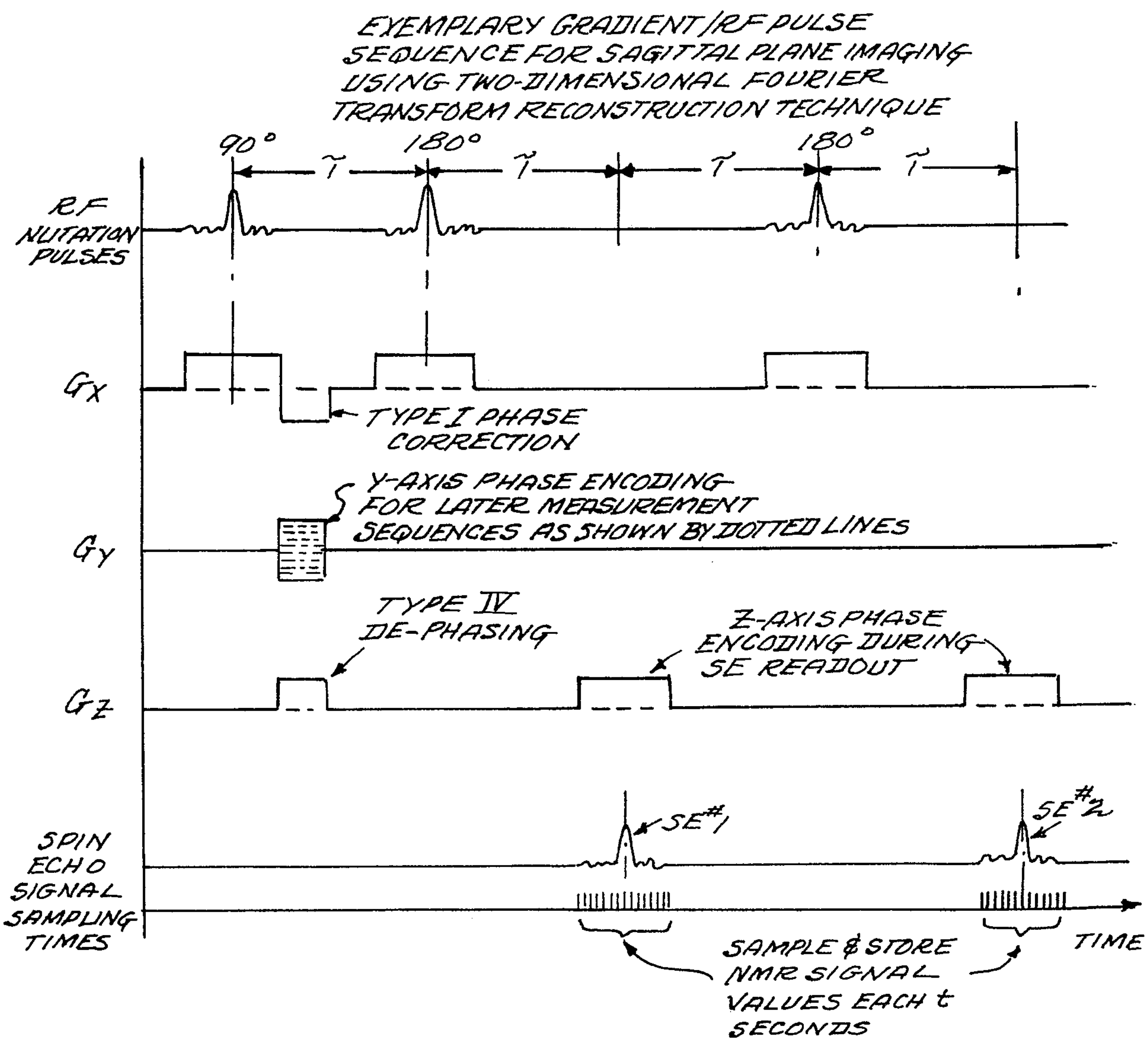
EXEMPLARY GRADIENT/RF PULSE SEQUENCE FOR SAGITTAL PLANE IMAGING USING TWO-DIMENSIONAL FOURIER TRANSFORM RECONSTRUCTION TECHNIQUE
90°
180°
180°
τ
RF NUTATION PULSES
$G_X$
TYPE I PHASE CORRECTION
$G_Y$
Y-AXIS PHASE ENCODING FOR LATER MEASUREMENT SEQUENCES AS SHOWN BY DOTTED LINES
$G_Z$
TYPE IV DE-PHASING
Z-AXIS PHASE ENCODING DURING SE READOUT
SPIN ECHO SIGNAL
SAMPLING TIMES
SE#1
SE#2
SAMPLE & STORE NMR SIGNAL VALUES EACH t SECONDS
TIME

F I G. 3

F I G. 4

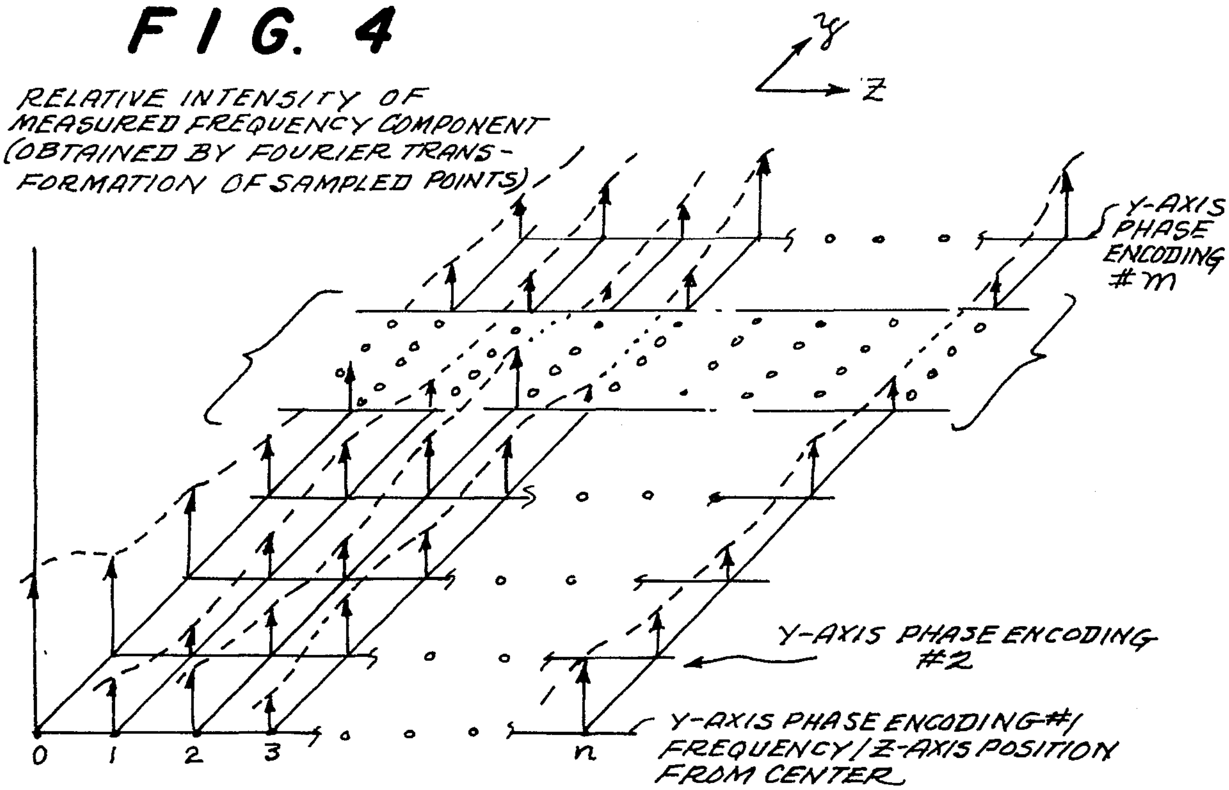


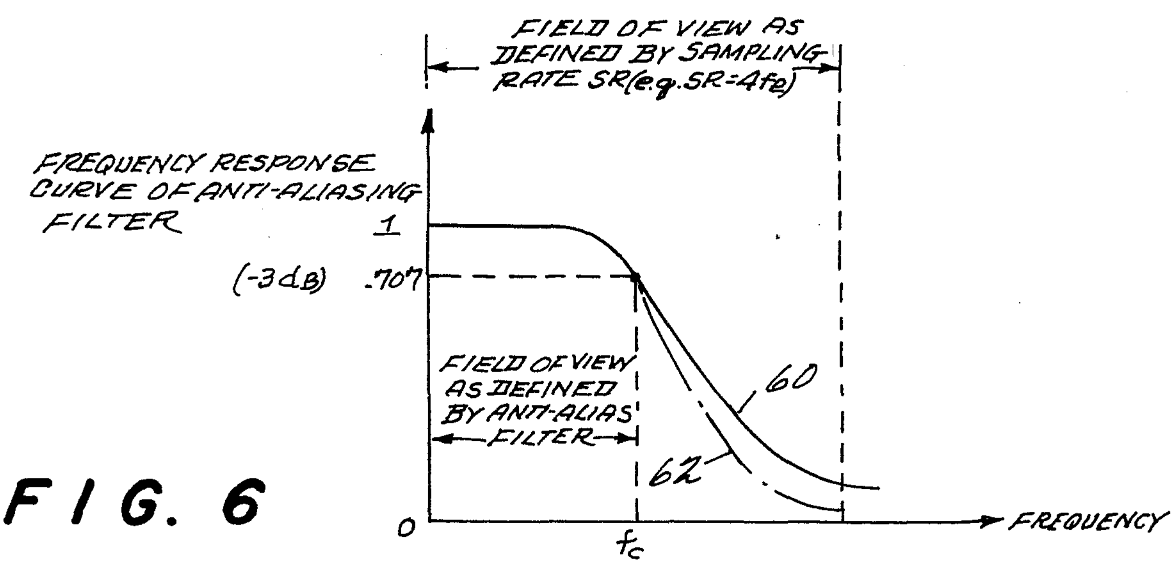


F I G. 6

USUAL SAMPLING RATE SR=2fc WHERE SR DEFINES FIELD OF VIEW.

REDUCED ALIASING WHERE SR>>2fc WHERE ANTI-ALIAS FILTER DEFINES APPARENT FIELD OF VIEW AND SR DEFINES LARGER RECONSTRUCTION FIELD OF VIEW

FIG.5A

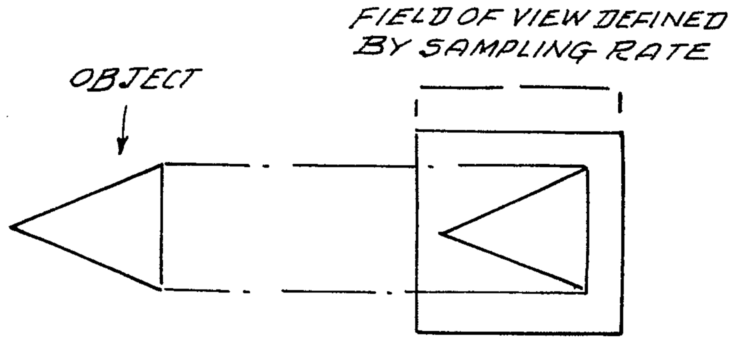


FIG.5B

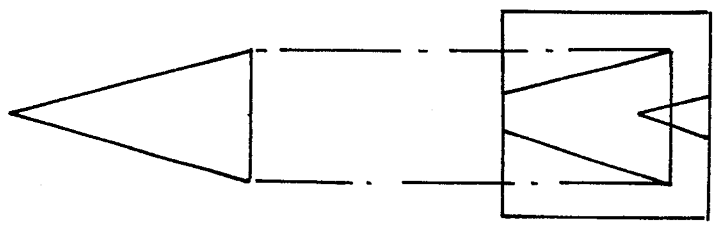

FIG.7A

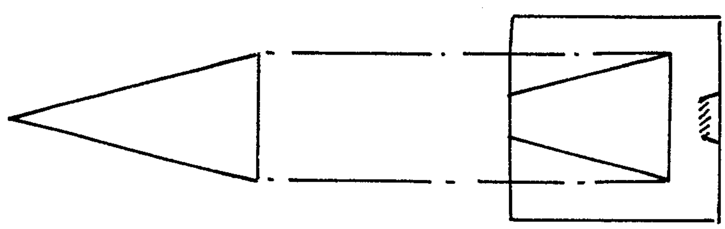

FIG.7B

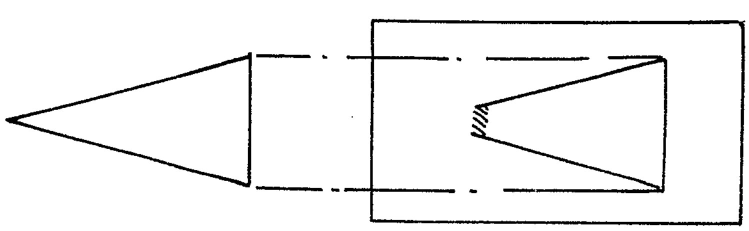

FIG. 8

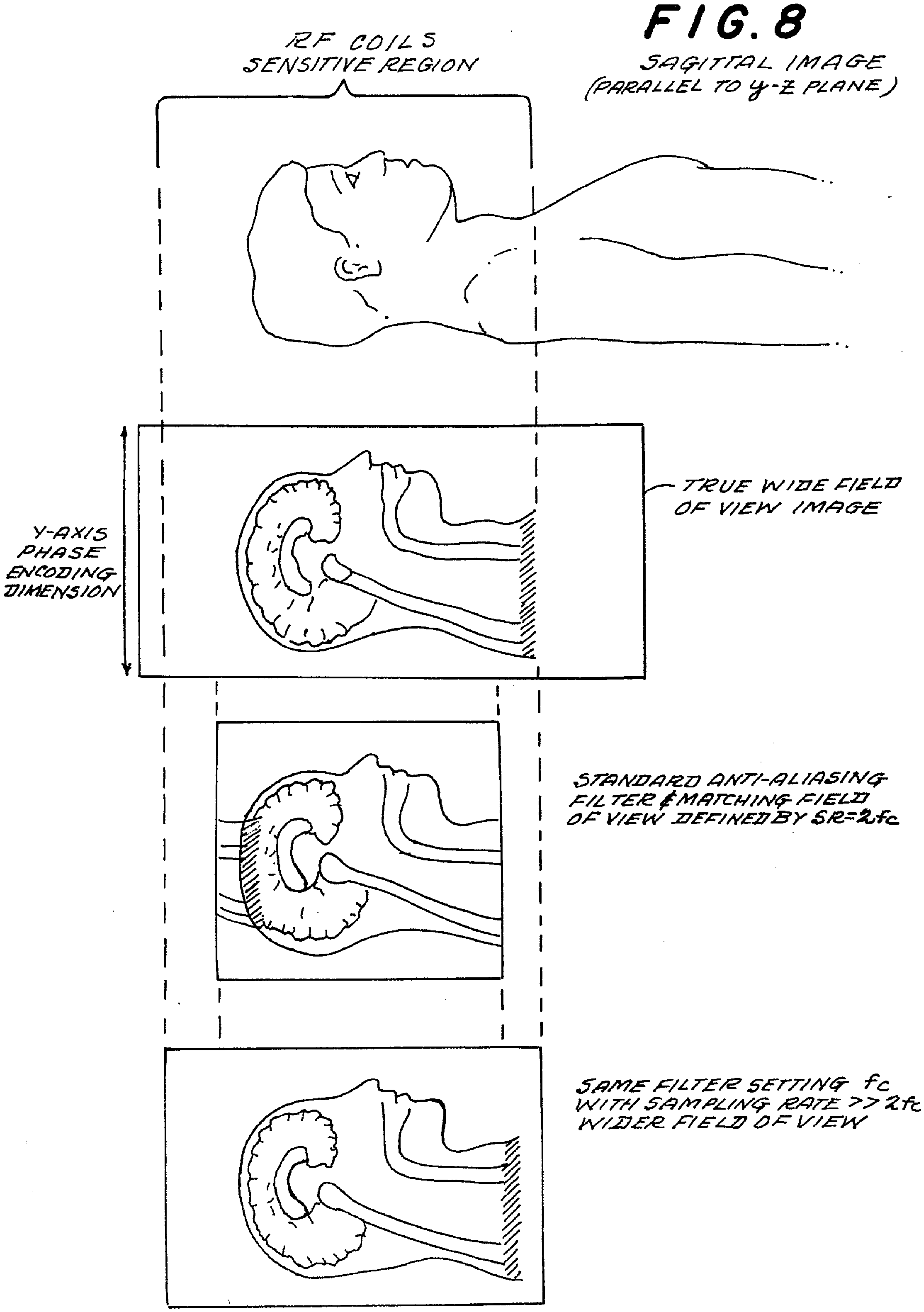

RF COILS SENSITIVE REGION
SAGITTAL IMAGE (PARALLEL TO y-z PLANE)
Y-AXIS PHASE ENCODING DIMENSION
TRUE WIDE FIELD OF VIEW IMAGE
STANDARD ANTI-ALIASING FILTER & MATCHING FIELD OF VIEW DEFINED BY SR=2fc
SAME FILTER SETTING fc WITH SAMPLING RATE >> 2fc WIDER FIELD OF VIEW

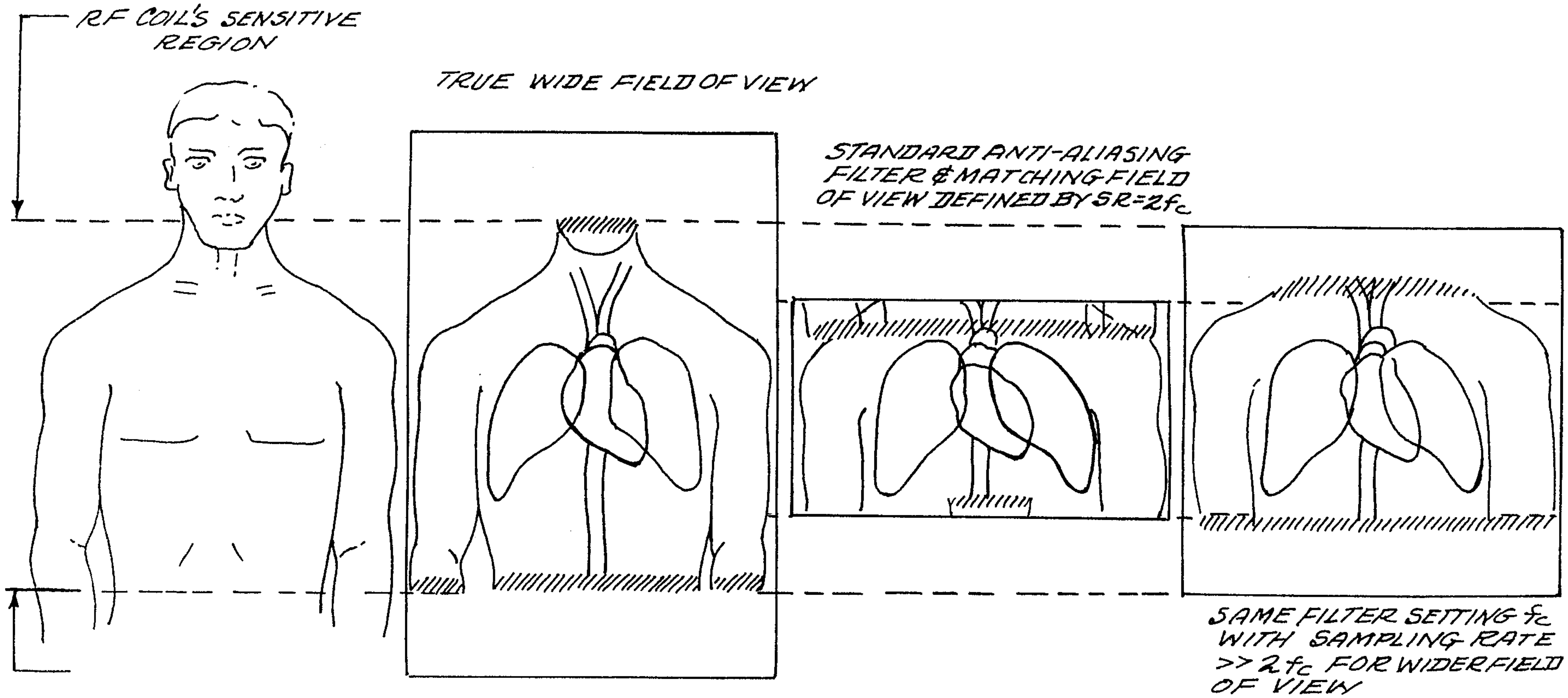


FIG. 9
CORONAL IMAGE
(PARALLEL TO X-Z PLANE)